# EUROPÄISCHE PATENTSCHRIFT

(11) **EP 2 428 987 B1**
(45) Veröffentlichungstag und Bekanntmachung des Hinweises auf die Patenterteilung: **08.01.2014**
(21) Anmeldenummer: 11007220.4
(22) Anmeldetag: 06.09.2011
(51) Int. Cl.: H01L 21/67, H01L 21/677, B65H 3/12, B28D 5/00

(54) **Vorrichtung und Verfahren zum Vereinzeln und Transportieren von Substraten**
Device and method for separating and transporting substrates
Dispositif et procédé destinés à l'isolation et au transport de substrats

(30) Priorität: 13.09.2010 DE 102010045098
(43) Veröffentlichungstag der Anmeldung: 14.03.2012
(73) Patentinhaber: RENA GmbH, 78148 Gütenbach (DE)
(72) Erfinder: Renn, Siegfried, 78628 Rottweil (DE); Dechant-Wagner, Roland, 78056 Villingen-Schwenningen (DE)
(74) Vertreter: Stürken, Joachim

(56) Entgegenhaltungen:
- DE-A1-102005 028 112
- DE-A1-102006 011 870
- DE-A1-102010 008 619

## Beschreibung

Die Erfindung ist eine Weiterentwicklung der in DE 10 2006 011 870 B4 offenbarten Technologie und bezieht sich auf eine Vorrichtung zum Vereinzeln und Transportieren von scheibenförmig ausgebildeten sowie bruchempfindlichen Substraten.

Ferner bezieht sich die Erfindung auf ein Verfahren zum Vereinzeln und Transportieren von in einem Substratstapel bereitgestellten Substraten.

Die "Substrate" sind scheiben- bzw. flächenförmig ausgebildet und in der Regel rechteckig. Sie werden nach einem Sägeprozess aus einem Substratblock gewonnen. Sie weisen umlaufende Kanten auf, die im Wesentlichen gerade ausgebildet sind, wobei die Ecken rechtwinklig, abgerundet oder abgeschrägt ausgestaltet sein können.

Mehrere aufeinander gestapelte oder nebeneinander bzw. hintereinander gestellte Substrate ergeben einen "Substratstapel". Verlaufen die Substratflächen horizontal, so wird erfindungsgemäß von einem "liegenden" Stapel übereinander liegender Substrate gesprochen; verlaufen die Substratflächen vertikal, so entspricht dies einem "stehenden" Stapel nebeneinander stehender Substrate. Die einzelnen Substrate sind bereits von einer für den Sägeprozess notwendigen Halteeinrichtung abgelöst und frei und unabhängig voneinander gestapelt. Häufig haften die einzelnen Substrate aufgrund des vorangegangenen Sägeprozesses jedoch noch ungewollt flächenartig zusammen. Für den Weiterbearbeitungsprozess ist es im Normalfall notwendig, diese so gestapelten Substrate zu vereinzeln. Dies bedeutet, dass das jeweils am Ende eines aufrecht positionierten Substratstapels bereitgestellte Substrat mittels einer Einrichtung von dem Substratstapel entnommen und in den weiteren Bearbeitungsprozess übergeben werden soll.

Die "Stapelrichtung" der Substrate in einem Substratstapel wird durch die Position des zu vereinzelnden Substrats vorgegeben. Die einzelnen Substrate sind derart ausgerichtet, dass sie mit ihren Flächen im Wesentlichen aneinanderliegend stehen. Die Stapelrichtung entspricht im Spezialfall exakt und vollständig einander anliegender Substratflächen genau der Richtung der Flächennormalen des Substrats bzw. der Substrate, wobei die positive Richtung auf dasjenige Ende des Stapels weist, von welchem das jeweils zu vereinzelnde Substrat abgenommen werden soll. Sofern dieses Substrat auf der rechten Seite des in einer Trägereinrichtung angeordneten "stehenden" Substratstapels angeordnet ist, zeigt die Stapelrichtung demnach in Pfeilrichtung rechts.

Die "Vorschubrichtung" eines Stapels wie auch die "Transportrichtung" entspricht im Wesentlichen der Stapelrichtung.

Der "Stapelanfang" und die "Stirnseite des Stapels" bezeichnen dasjenige Ende des Substratstapels, an welchem sich das nächste zu vereinzelnde Substrat befindet. Das ist dasjenige Ende, welches in Vorschubrichtung zeigt. Wird jedoch allgemein von "Stapelende" gesprochen, so ist nicht näher bezeichnet, ob es sich um den Stapelanfang oder das entgegengesetzte Ende des Stapels handelt.

Die im Wesentlichen senkrecht bzw. aufrecht positionierten Substratstapel werden in einer "Trägereinrichtung" bereitgestellt. Dabei liegt eine Kante des jeweiligen Substrats auf der Trägereinrichtung auf. Die Trägereinrichtung nimmt den Substratstapel beispielsweise nach dem Sägen und/oder dem Entfernen des häufig zum Befestigen der zunächst ungesägten Substrate auf eine Halteplatte benutzten Klebers auf und transportiert diesen zu einer Entnahmeeinrichtung, in welcher die Vereinzelung erfolgen soll. Die Trägereinrichtung ist bevorzugt derart ausgebildet, dass sie den Substratstapel als Ganzes aufnimmt, d. h. die einzelnen Substrate stehen im Wesentlichen flächig aneinander- bzw. hintereinanderliegend.

Insbesondere zur Vereinfachung des Transports der mit Substraten befüllten Trägereinrichtung kann diese vorteilhaft mit zwei seitlich und parallel zueinander angeordneten in Vorschubrichtung verlaufenden Bürstenleisten ausgestattet sein, mit denen die Substrate im Stapel ggf. bis zu ihrer jeweiligen Entnahme in Position gehalten werden können. Hierzu sind die Leisten über geeignete Klapp- oder Verschwenkmittel derart mit der Trägereinrichtung verbunden, dass die Einrichtung leicht beladen und die Substrate des Stapels gewünschtenfalls bis zu ihrer jeweiligen Vereinzelung sicher in Position gehalten werden können. Aufgrund der Klapp- oder Verschwenkbarkeit der Bürstenleisten kann ihre Haltefunktion nach Bedarf genutzt werden.

Unter "Adhäsion" werden erfindungsgemäß zwischen zwei Flächen wirkende Kräfte verstanden, die durch Annäherung dieser beiden Flächen ausgebildet werden. Da die erfindungsgemäß beschriebenen Adhäsionskräfte in einem Fluid entstehen sollen, ist es erforderlich, dass das zwischen den beiden Flächen befindliche Flüssigkeitsvolumen reduziert wird, was grundsätzlich durch Verdrängung und/oder Absaugen realisiert werden kann. Um der erfindungsgemäß gestellten Aufgabe einer möglichst schonenden Handhabung der Substrate zu entsprechen, erfolgt die Reduzierung des Volumens nur soweit, dass zwischen den Flächen ein Fluid- bzw. Flüssigkeitsfilm verbleibt.

Die "Entnahme- oder Vereinzelungseinrichtung" dient zum Entnehmen bzw. Vereinzeln und Abtransportieren eines Substrats vom Substratstapel. Dabei wird das an dem einen Ende des zu vereinzelnden Substratstapels angeordnete Substrat von der Entnahme- oder Vereinzelungseinrichtung über Saugeinrichtungen aufgegriffen, von dem Substratstapel abgelöst und damit vereinzelt, und einem weiteren Bearbeitungs- oder Transportprozess zugeführt. Die Entnahmeeinrichtung dient dazu, das zu vereinzelnde Substrat aus dem Substratstapel zu entfernen, wobei die "Entnahme" bzw. "Vereinzelung" in im Wesentlichen vertikaler Richtung erfolgt. Mit anderen Worten wird das zu vereinzelnde Substrat durch Verschieben gegenüber dem nachfolgenden Substrat in Richtung seiner flächigen Erstreckung, vorzugsweise ungefähr senkrecht zur Ebene der Trägereinrichtung, nach oben verschoben bzw. entfernt, so dass zwischen den beiden Substraten vorteilhaft lediglich Scherkräfte entstehen.

Je nach Entnahmerichtung wirken daher unterschiedliche Kräfte unterschiedlicher Stärke auf das zu vereinzelnde Substrat und die noch im Stapel befindlichen Substrate ein, wobei diesen Kräften vor allem das dem gerade zu entnehmenden Substrat folgende Substrat ausgesetzt ist.

Zum Vereinzeln des Substratstapels ist vorgesehen, diesen zusammen mit der Trägereinrichtung in einem Fluid anzuordnen, worunter hierbei im Wesentlichen flüssige Medien zu verstehen sind. Innerhalb des Fluids sind "Strömungseinrichtungen" vorgesehen, die den Substratstapel von der bzw. den Seiten und/oder von unten bzw. oben mit Fluid derart beströmen, dass eine Strömung erzielt wird, die auf den Substratstapel zielt und bewirkt, dass die einzelnen Substrate "auffächern" und im Abstand zueinander gehalten werden. Dies bedeutet, dass zwischen den einzelnen Substraten ein Zwischenraum entsteht, der mit Fluid gefüllt ist und die Funktion eines fluiden Dämpfungskissens erfüllen kann.

Dieses Auffächern kann nach einer bevorzugten Ausführungsform noch mit weiteren geeigneten Mitteln wie z.B. mit insbesondere im Auffächerungsbereich positionierten Ultraschallstrahlern unterstützt werden. Dies ist insbesondere dann vorteilhaft, wenn die Adhäsionskräfte zwischen den einander berührenden Substraten derart hoch sind, dass ein Eindringen des Fluids ansonsten nur sehr langsam erfolgt.

In der WO 01/28745 A1 werden Verfahren und Einrichtungen zum Ablösen von scheibenförmigen Substraten beschrieben, wobei die Vereinzelung im Trockenen, also außerhalb eines Flüssigkeitsbades erfolgt. Lediglich durch Düsen kann eine Befeuchtung der Substrate stattfinden. Eine roboterartige Einrichtung greift das abzulösende Substrat über Saugeinrichtungen (aktive Erzeugung eines Gas-Unterdruckes über z.B. eine Vakuumpumpe), wodurch das Substrat durch eine oszillierende Bewegung der Einrichtung von der Halteeinrichtung gelöst wird. Dabei sind oszillierende Bewegungen in unterschiedliche Richtungen vorgesehen. Das Greifen des zu vereinzelnden Substrats erfolgt mit Hilfe einer über der Fläche des Substrats angeordneten und an der Einrichtung befestigten Saugeinrichtung. Zur Freigabe des Substrats wird innerhalb der Saugeinrichtung ein gewisser Gas-Überdruck erzeugt, so dass das abgelöste Substrat wieder von der Einrichtung entfernbar ist.

Aus der DE 199 00 671 A1 sind Verfahren und Vorrichtungen zum Ablösen von scheibenförmigen Substraten wie insbesondere von Wafern bekannt. Es wird vorgeschlagen, die unmittelbar nach dem Sägevorgang aneinander haftenden Substrate, die mit ihrer einen Seite (Kante) noch an der Halteeinrichtung befestigt sind, durch einen gezielten Fluidstrahl voneinander im Abstand zu halten. Eine Keileinrichtung sorgt dafür, dass eine Trennung des abzulösenden Substrats von der Halteeinrichtung erfolgt. Gleichzeitig wird das vereinzelte Substrat mittels einer Saugeinrichtungen aufweisenden greifarmähnlichen Einrichtung aus der Halteeinrichtung entnommen.

Aus der DE 697 22 071 T2 ist eine Vorrichtung für das Einlegen von durch Zersägen eines Substratblocks erhaltenen Wafern in ein Aufbewahrungselement bekannt. Es werden Handhabungsvorrichtungen vorgeschlagen, die es erlauben, im Querschnitt runde oder ovale Substrate zu ergreifen und diese in ein ständerartiges Gebilde zu überführen. Dabei werden mehrere Substrate gleichzeitig aufgenommen und auf eine Stellfläche überführt, welche die vereinzelten Substrate aufnimmt.

Aus der DE 199 04 834 A1 ist eine Vorrichtung zum Ablösen von einzelnen dünnen, bruchempfindlichen und scheibenartigen Substraten bekannt. Der Substratblock mit den bereits gesägten Substraten befindet sich in einem mit einem Fluid gefüllten Behälter. Im Gegensatz zum bisher bekannten Stand der Technik ist die Halteeinrichtung zusammen mit den noch an der Halteeinrichtung fixierten Substraten senkrecht ausgerichtet, so dass das zu vereinzelnde Substrat parallel zur Fluidoberfläche angeordnet ist. Eine Keileinrichtung sorgt dafür, dass eine Trennung zwischen der Glasplatte und dem zu vereinzelnden Substrat stattfindet. Ein in unmittelbarer Nähe zum Substrat angeordnetes Transportband sorgt dafür, dass die abgelösten und aufschwimmenden Substrate abtransportiert werden. Eine Schiebeeinrichtung sieht vor, dass die Halteeinrichtung immer wieder in die gleiche Position gebracht und horizontal gegen die Keileinrichtung zur Ablösung des jeweiligen Substrats gefahren wird. Auf der anderen Seite des Förderbandes ist eine

Einrichtung vorgesehen, mit der die vereinzelten Substrate automatisch in einen Ständer eingefügt werden. Ziel der Ablösung ist es, dass die abgetrennten, scheibenartig ausgebildeten Substrate nach ihrer Entfernung von der Halteeinrichtung gestapelt und in vorbestimmte Einrichtungen eingefügt oder unmittelbar planmäßig aufeinander gelegt werden.

Auch die EP 0 762 483 A1 zeigt eine Vorrichtung, mit welcher unter anderem die Vereinzelung von flächigen Substraten erfolgen kann. Die Substrate liegen bereits vereinzelt in einer Trageeinrichtung bereit, wo sie sich zunächst noch flächig berühren. Zur Vereinzelung und Überführung in einen Behälter werden die Substrate mittels eines Schiebers und ggf. unter Zuhilfenahme von Walzen und/oder Flüssigkeitsstrahlen vom Stapel wegtransportiert, wobei sich die Substrate zwingend in einer horizontalen, also liegenden Position befinden müssen. Entsprechend der zuvor erfolgten Klarstellung sind die Substrate also in Form eines "liegenden" Stapels übereinander liegender Substrate angeordnet. Alternativ zeigt die Druckschrift eine Vereinzelung durch Verwendung eines Sauggreifers, welcher während des gesamten Greif- und Transportvorgangs mit Gas-Vakuum zu versorgen ist und das Substrat direkt berührt, also ohne einen schützenden Fluidfilm zwischen Greifer und Substratfläche.

Die möglichst schonende Vereinzelung der jeweiligen Substrate gestaltet sich nach den bekannten Verfahren jedoch schwierig und leidet an einer Reihe von Nachteilen.

Für das Vereinzeln sind Bewegungen notwendig, die komplexe Einrichtungen erfordern, sofern man auf eine manuelle Bedienung verzichten möchte. Da es sich jedoch bei den Substraten um sehr bruchempfindliche und dünne, plattenartig ausgestaltete Substrate handelt, können diese nicht ohne weiteres über herkömmliche greifarmähnliche Systeme aufgenommen werden. Hierzu ist es notwendig, sehr präzise und feinfühlige Einrichtungen vorzusehen.

Aus dem zuvor dargelegten Stand der Technik sind somit im Wesentlichen solche Einrichtungen bekannt, die das jeweilige Substrat mittels einer Saugeinrichtung ergreifen. Unmittelbar nach dem Anfahren der Saugeinrichtung an die flächige Ausgestaltung des zu vereinzelnden Substrats wird zwischen Saugeinrichtung und zu vereinzelndem Substrat über eine Vakuumpumpe ein Gas-Vakuum erzeugt, so dass ein Anhaften des Substrats an einer Handhabungseinrichtung möglich ist. Es ist jedoch Vorsicht geboten, da das zu vereinzelnde Substrat durch zu hohen Unterdruck zu Bruch gehen kann.

Im Gegensatz zu diesen Verfahren, bei denen zwischen zwei Flächen Vakuum bzw. ein Unterdruck von mindestens 1 mbar einzustellen ist, wird die erfindungsgemäße Adhäsion unter Beibehaltung eines Fluid- bzw. Flüssigkeitsfilms zwischen den Flächen durch einen Unterdruck herbeigeführt, der sehr viel schwächer als ein Vakuum ist und beispielsweise zwischen 0,3 und 0,5 bar wie vorzugsweise etwa 0,4 bar beträgt.

Ein weiterer kritischer Punkt hierbei besteht darin, dass das jeweilige Substrat von der Handhabungseinrichtung angefahren, d.h. berührt werden muss. Da das Substrat von der Einrichtung in keinem Fall weggedrückt werden darf, ist eine exakte Positionierung notwendig. Dies gestaltet sich jedoch schwierig, da zum einen eine Relativbewegung der Halteeinrichtung zur Positionierung des zu vereinzelnden Substrats im Bereich der Halteeinrichtung vorgesehen ist, und die Halteeinrichtung selbst damit entsprechende Freiheitsgrade aufweist. Daher sind Toleranzen möglich, die zur möglichen Beschädigung des zu vereinzelnden Substrats führen. Zum anderen finden solche Bewegungen in der Regel in einem Fluid statt, so dass Gefahr besteht, dass durch die einzelnen Bewegungen der Einrichtungen ein Strömungsdruck, insbesondere in Richtung der Substrate, entsteht, der zu Positionsverschiebungen der Substrate oder sogar zu Bruch führen kann.

Eine von Hand durchgeführte Vereinzelung birgt die Gefahr, dass die sehr dünnen und bruchempfindlichen sowie scheibenförmig ausgebildeten Substrate insbesondere aufgrund der erhöhten Adhäsionskräfte zerbrechen.

Die der vorliegenden Erfindung zur Verbesserung zugrunde liegende Vereinzelungsvorrichtung gemäß DE 10 2006 011 870 B4 weist eine Wanne mit Flüssigkeit auf, in der der Stapel mit den zu vereinzelnden Substraten angeordnet ist, wobei die Substrate des Stapels Siliziumplatten sind, die direkt aus der Flüssigkeit der Wanne heraus vereinzelt werden. Dabei taucht das fördernde Trum mit dem Anfang seiner Förderstrecke derart in die Flüssigkeit ein, dass sich dessen förderndes Trum entfernt von der Stirnseite des Stapels (Stapelende) parallel zur Stirnseite des Stapels (Stapelanfang) erstreckt. Die Vereinzelung erfolgt durch Ansaugen der Substrate an einen Fördergurt des Gurtförderers, wobei anstelle von Luft, wie zumeist in herkömmlichen Vorrichtungen, die in der Wanne befindliche Flüssigkeit mittels der Unterdruckeinrichtung des Gurtförderers angesaugt wird. Die Unterdruckeinrichtung ist an dem Gurtförderer vorgesehen, mit dem ein vorderstes Substrat des Stapels zusammen mit der das Substrat umgebenden Flüssigkeit angesaugt wird, bis das Substrat an dem Fördergurt anliegt und durch einen Unterdruck der Unterdruckeinrichtung am Fördergurt festgelegt ist.

Die mit der Vorrichtung zu vereinzelnden Substrate können einander berühren oder voneinander beabstandet den Stapel bilden, wobei die Substrate immer parallel zueinander und zu einem fördernden Trum des Gurtförderers angeordnet sind. Das am Fördergurt festgelegte Substrat wird mit dem Fördergurt mitbewegt und parallel zu einer Stirnseite des Stapels von dem Stapel weg transportiert. Dabei kann der Fördergurt kontinuierlich oder getaktet, mit gleichbleibender oder variierender Geschwindigkeit angetrieben sein. Bei einer Taktung ist es erforderlich, die Position des Substrates und/oder des Fördergurtes mittels eines Sensors zu detektieren, der beispielsweise als Drucksensor der Unterdruckeinrichtung oder als Lichtschranke vor dem fördernden Trum angeordnet sein kann. Bei einem kontinuierlichen Antrieb kann oder muss der Gurtförderer angehalten werden, wenn der Sensor kein Substrat in Abholposition auf dem Fördergurt detektiert. Der Gurtförderer fährt wieder an, wenn ein Substrat bereit steht.

Der Gurtförderer kann als Horizontal- oder Vertikalförderer ausgebildet sein oder beide Förderrichtungen miteinander kombinieren. In Abhängigkeit von der Neigung der Transportstrecke ist es notwendig, das Substrat mit einer auf das Substrat einwirkenden Kraft gegen den Fördergurt zu pressen, um eine ausreichende Reibkraft zwischen dem Substrat und dem Fördergurt zu erreichen. Dies kann beispielsweise durch Ansaugen mittels der Unterdruckeinrichtung oder durch Anpressen mittels Stützgurten oder Stützrollen erfolgen, die das Substrat zwischen sich und den Fördergurt klemmen. So ist es möglich, den plattenförmigen Gegenstand aus einer stehenden Stellung im Stapel in eine liegende Stellung am Ende der Transportstrecke zu überführen.

In einer vorteilhaften Ausführungsform ist der Gurtförderer ein Vertikalförderer, der das zu vereinzelnde plattenförmige Substrat aus einer stehenden Stellung vom Stapel übernimmt, vereinzelt und in der stehenden Stellung von dem Stapel weg in vertikaler Richtung, vorzugsweise senkrecht nach oben, fördert. Eine Förderstrecke des Gurtförderers kann mehrere hintereinander angeordnete Fördergurte aufweisen, wobei mindestens der erste abstapelnde Fördergurt die Unterdruckeinrichtung zur Ansaugung der Substrate aufweist. Dabei wird nicht ausgeschlossen, dass der Fördergurt von mehreren nebeneinander angeordneten einzelnen, zusammen wirkenden Fördergurten gebildet ist. Weist die Förderstrecke mehrere aufeinander folgende Fördergurte auf, können sie gemeinsam angetrieben sein. Alternativ können Fördergurte der Förderstrecke einen eigenen Antrieb aufweisen. Das ermöglicht einen größeren Abstand zwischen den geförderten plattenförmigen Substraten durch Auseinanderziehen mit unterschiedlichen Gurtgeschwindigkeiten oder vorübergehendes Anhalten eines vorangehenden Fördergurtes.

In einer weiteren vorteilhaften Ausführungsform weist der Gurtförderer einen nicht linearen Verlauf auf. Dies kann dadurch erreicht werden, dass der Fördergurt entlang einer gekrümmten Bahn geführt ist oder mehrere hintereinander angeordnete Fördergurte in einem Winkel zueinander angeordnet sind.

Vorteilhafterweise ist mindestens ein Fördergurt, vorzugsweise der abstapelnde Fördergurt am Anfang der Transportstrecke des Gurtförderers, getaktet. Dies hat den Vorteil, dass der abstapelnde Fördergurt beim Ansaugen des Substrates nicht entlang einer zum fördernden Trum weisenden Oberseite des Substrates entlangschleift und diese, insbesondere bei empfindlichen Gegenständen, beschädigt. Der Fördergurt der Vereinzelungsvorrichtung steht still, solange kein Substrat an den Fördergurt angesaugt ist. Sobald ein Substrat an dem Fördergurt anliegt und festgesaugt ist, gibt ein Sensor der Unterdruckeinrichtung des Gurtförderers den Antrieb des Fördergurtes frei und das Substrat wird ohne Relativbewegung zu dem Fördergurt von dem Fördergurt mitgenommen.

In einer weiteren vorteilhaften Ausführungsform der Vereinzelungsvorrichtung weist mindestens ein Fördergurt, insbesondere der abstapelnde Fördergurt, in mindestens einem Bereich ein definiertes Lochbild zur Ansaugung und Fixierung des Substrates am Fördergurt auf. Das Lochbild kann ein oder mehrere Löcher aufweisen, die nicht zwingend rund sein müssen und die auch miteinander verbunden sein können. Das definierte Lochbild ist vorzugsweise entsprechend dem Substrat ausgeführt, so dass seine Löcher vollständig durch das Substrat abdeckbar sind. Der Fördergurt kann mehrere solche Lochbilder entlang seinem Umfang aufweisen, die vorzugsweise im gleichen Abstand voneinander angeordnet sind. Zur Aufnahme des Substrates durch den abstapelnden Fördergurt wird das Lochbild des Fördergurtes gegenüber der Stirnseite des Stapels positioniert und dann angehalten, wobei der Stapel mittels seines Antriebes zum Lochbild hin bewegt und das Substrat angesaugt wird, während der Fördergurt stillsteht. Dabei kann die Unterdruckeinrichtung des Gurtförderers deaktiviert sein, bis das Substrat von einem Sensor erkannt wird, der die Unterdruckeinrichtung steuert. Zum Lösen des Substrates von dem Fördergurt wirkt die Unterdruckeinrichtung des Gurtförderers in Bereichen der Förderstrecke nicht, so dass das Substrat einfach abgelegt oder übergeben werden kann.

In einer bevorzugten Ausführungsform der DE 10 2006 011 870 B4 weist der Gurtförderer Führungselemente zur Ausrichtung und/oder Umlenkung des plattenförmigen Gegenstandes auf, die auf den Gegenstand einwirken, sobald dieser nicht mehr durch Unterdruck an dem Fördergurt gehalten ist. Mittels der Führungselemente kann in Abhängigkeit von deren Ausführung der Gegenstand in seiner Lage auf dem Fördergurt gehalten, auf dem Fördergurt ausgerichtet oder vom Fördergurt weg gelenkt werden.

In einer weiteren bevorzugten Ausführungsform der Vereinzelungsvorrichtung sind im Bereich des fördernden Trums Separiermittel angeordnet, die ein Anhaften des dem Trum jeweils nächststehenden Substrates an dem Stapel verhindern. Die Separiermittel können beispielsweise ein vorderstes Substrat des Stapels gegenüber dem dahinter befindlichen Substrat ausrichten und wenn notwendig trennen. Dabei kann eine Trennung aneinander in Teilbereichen anliegender Substrate durch berührende oder berührungslose Einwirkung erfolgen. Die Trennung kann beispielsweise mittels eines mechanischen Manipulators oder mit einer Fluidströmung erfolgen, welche(r) zumindest auf die beiden dem fördernden Trum jeweils nächstliegenden plattenförmigen Substrate einwirkt.

Bei dem in der DE 10 2006 011 870 B4 offenbarten Verfahren zur stückweisen Bereitstellung plattenförmiger Substrate aus einem stehend angeordneten Stapel mit einem Gurtförderer mit Fördergurt(en), dessen förderndes Trum auf einer Stirnseite des Stapels parallel zur Stirnseite angeordnet ist, und mit einem Antrieb zum Bewegen des Stapels in Richtung des Trums, wobei der Gurtförderer eine Unterdruckeinrichtung aufweist, mit der ein oberstes Substrat des Stapels an mindestens einem ersten Fördergurt ansaugbar ist, erfolgt die Vereinzelung in folgenden Schritten:
(A) Bereitstellen eines Stapels mit plattenförmigen Substraten in Form von Siliziumplatten in einer Flüssigkeit enthaltenden Wanne vor dem fördernden Trum des Gurtförderers;
(B) Positionieren eines definierten Lochbildes in der Wanne eines ersten Fördergurtes gegenüber der Stirnseite des Stapels;
(C) Bewegen des Stapels in Richtung des ersten Fördergurtes und in eine Ansaugposition;
(D) Detektieren der Ansaugposition des dem ersten Fördergurt nächstliegenden Substrates und Trennung des Substrates in der Wanne von dem Stapel;
(E) Ansaugen des Substrates in der Wanne mittels Unterdruck an das Lochbild des ersten Fördergurtes;
(F) Detektieren des angesaugten Substrates und Auslösen eines Fördertaktes des ersten Fördergurtes;
(G) Bewegen des Substrates mit dem Fördergurt aus der Wanne und Schwenken des Substrates gegenüber der Stirnseite des Stapels beim Fördern mit dem Gurtförderer;
(H) Lösen und Trennen des Gegenstandes von dem ersten Fördergurt;
(I) Positionieren des definierten Lochbildes des ersten Fördergurtes gegenüber der Stirnseite des Stapels beim Beenden des Fördertaktes des Fördergurtes; und
(J) Wiederholung der Schritte (C) bis (I), bis der Stapel komplett vereinzelt ist.

In einer optimierten Variante des in der DE 10 2006 011 870 B4 offenbarten Verfahrens wird die Unterdruckeinrichtung erst aktiviert, wenn das dem Fördergurt nächstliegende Substrat in seiner Ansaugposition detektiert ist.

Eine vorteilhafte Weiterbildung des vorangehend beschriebenen Verfahrens sieht vor, dass das am ersten Fördergurt angesaugte Substrat von der Stirnseite des Stapels weg und zu einem zweiten, an den ersten Fördergurt anschließenden Fördergurt hin transportiert wird, der einen gegenüber dem ersten Fördergurt geringeren Neigungswinkel aufweist, und der Gegenstand an den zweiten Fördergurt zum Weitertransport übergeben wird.

Gemäß einem anderen bevorzugten Verfahrensablauf wird die Unterdruckeinrichtung beim Übergeben des Gegenstandes an den zweiten Fördergurt deaktiviert.

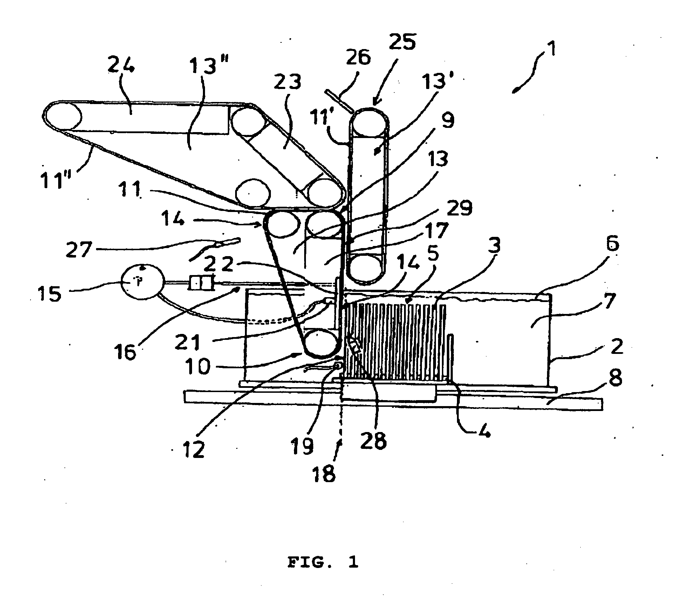

Vorstehend wurden die Merkmale der erfindungsgemäß weiter zu bildenden Technologie gemäß DE 10 2006 011 870 B4 dargelegt. Hinsichtlich ergänzender Informationen sowie einer detaillierten Darlegung der Vorgehensweise zur Vereinzelung wird auf die Figur 1 sowie auf die nachfolgende Beschreibung dieser Figur verwiesen. Mit dieser Technik lässt sich ein Stapel bereitgestellter Substrate relativ schonend und automatisiert vereinzeln. Nachteilig sind jedoch der aufgrund der Verwendung von insgesamt drei Fördergurten erforderliche apparative Aufwand sowie das durch die Führungselemente des Gurtförderers gegebene Risiko einer Beschädigung des geförderten Substrates.

Die Aufgabe der Erfindung besteht daher in der Bereitstellung einer verbesserten Vorrichtung und eines diese verbesserte Vorrichtung einsetzenden Verfahrens, mit denen ein nahezu beschädigungsfreies Entnehmen von dünnen, bruchempfindlichen und gestapelten Substraten bei vergleichsweise erheblich geringerem apparativen Aufwand ermöglicht wird.

Hinsichtlich der erfindungsgemäß benötigten Komponenten und deren Wirkungsweise wird ausdrücklich auf die Ausführungen zum Stand der Technik gemäß DE 10 2006 011 870 B4 verwiesen und Bezug genommen. Daher werden nachstehend nur die erfindungsgemäßen Unterschiede zu diesem Stand der Technik erläutert.

Die Aufgabe wird erfindungsgemäß durch Bereitstellung einer verbesserten Vorrichtung gemäß Anspruch 1 sowie eines die verbesserte Vorrichtung einsetzenden Verfahrens gemäß Anspruch 7 gelöst.

Die vorliegende Erfindung betrifft daher eine Vorrichtung zum Vereinzeln, Umlenken und Transportieren von scheibenförmig ausgebildeten Substraten, die in einer Vorschubrichtung sequenziell hintereinander stehend in Form eines Substratstapels innerhalb einer Flüssigkeit angeordnet sind, umfassend einen vertikalen Gurtförderer mit mindestens zwei unmittelbar aneinander angrenzenden Fördergurten, wobei das fördernde Trum eines ersten Fördergurtes auf einer Stirnseite des Substratstapels parallel zur Stirnseite angeordnet ist und der Gurtförderer eine Unterdruckeinrichtung aufweist, mit der das jeweils vorderste Substrat des Substratstapels an mindestens dem ersten Fördergurt ansaugbar ist, und wobei die mindestens zwei Fördergurte des vertikalen Gurtförderers in einem angrenzenden Bereich derart koplanar zueinander angeordnet sind, dass sich der zweite Fördergurt unter Fortsetzung des vertikalen Verlaufs des ersten Fördergurtes an diesen anschließt. Erfindungsgemäß entspricht die Länge des koplanar zum ersten Fördergurt angeordneten Bereichs des zweiten Fördergurtes in vertikaler Förderrichtung mindestens einem Drittel der Substratlänge, wobei der zweite Fördergurt im Anschluss an seinen koplanaren Bereich zwei Förderschenkel umfasst, deren erster Förderschenkel im Anschluss an den koplanaren Bereich vorzugsweise geneigt verläuft.

Der wesentlichste Unterschied zur Vorrichtung gemäß DE 10 2006 011 870 B4 besteht darin, dass auf sämtliche der zuvor erwähnten Führungsmittel wie insbesondere auf das parallel zum Ansaugband angeordnete Abstützungsband mit Fördergurt verzichtet werden kann.

Wie vorliegend ausgeführt, verlangt die DE 10 2006 011 870 B4 in der bevorzugten Ausführungsform eines vertikalen Gurtförderers, das Substrat mittels einer auf das Substrat einwirkenden Kraft gegen den Fördergurt zu pressen, um eine ausreichende Reibkraft zwischen dem Substrat und dem Fördergurt zu erreichen. Hierzu wird insbesondere die Verwendung eines parallel zum Ansaugband oder Fördergurt angeordneten Abstützungsbandes oder Stützgurtes vorgeschlagen, wodurch das Substrat wirksam eingeklemmt und gegen ein Wegfallen entgegen der Vorschubrichtung gesichert werden kann.

Erfindungsgemäß hat sich überraschenderweise herausgestellt, dass das entnommene und an dem ersten Fördergurt des Ansaugbandes mittels Unterdruck fixierte Substrat auch während oder nach der Übergabe auf den in Entnahmerichtung direkt anschließenden zweiten Fördergurt des Transportbandes sicher am Gurtförderer haftend verbleibt und vor einem Wegfallen entgegen der Vorschubrichtung geschützt ist. Wie zuvor ausgeführt, wird der erste Fördergurt als Teil des Ansaugbandes erfindungsgemäß bevorzugt nicht mit einem Vakuum im Bereich von mindestens 1 mbar, sondern mit einem geringeren Unterdruck beaufschlagt, der beispielsweise zwischen 0,3 und 0,5 bar wie vorzugsweise etwa 0,4 bar beträgt. Diese schwächeren Unterdrücke ermöglichen eine Reduzierung der auf die Substrate einwirkenden Kräfte und führen zur Ausbildung der gewünschten Adhäsionskraft, wobei zwischen den Flächen der Substrate und den Fördergurten ein Fluid- bzw. Flüssigkeitsfilm beibehalten wird.

Da der vom Transportband umfasste zweite Fördergurt der in DE 10 2006 011 870 B4 offenbarten Vorrichtung zwar unmittelbar an den ersten Fördergurt des Ansaugbandes anschließt, der Substratfläche in vertikaler Richtung jedoch nur eine eine Linienberührung ermöglichende und damit nicht ausreichende Fläche zur Ausbildung einer Adhäsion bereitstellt, kann das Substrat nicht gegen ein Wegfallen entgegen der Vorschubrichtung gesichert werden, weshalb das vorgeschlagene

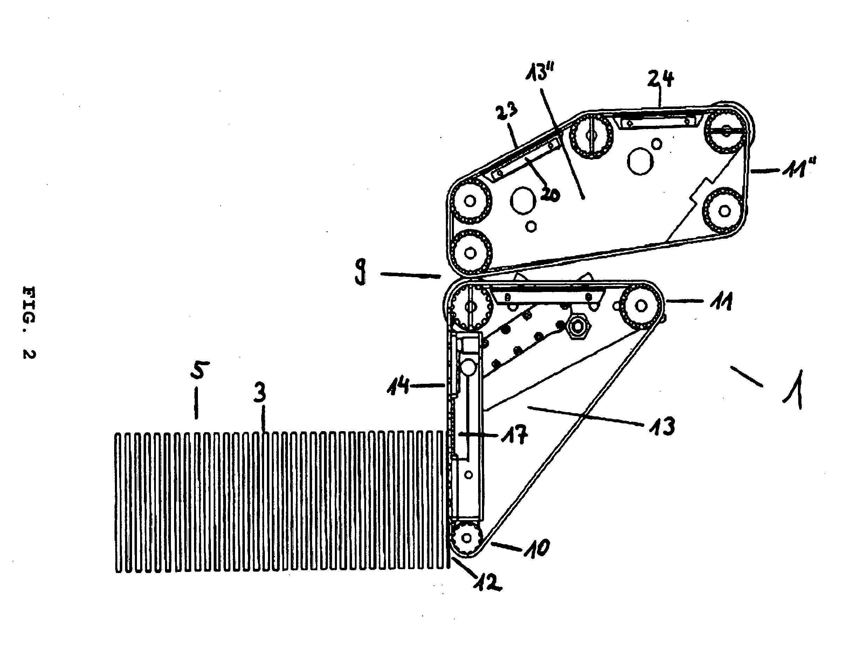

Abstützungsband zwingend erforderlich ist. Demgegenüber sind die mindestens zwei Fördergurte des vertikalen Gurtförderers im angrenzenden Bereich erfindungsgemäß koplanar zueinander angeordnet, wodurch der Substratfläche eine zur Beibehaltung der Adhäsionskräfte ausreichend große Fläche des zweiten Fördergurtes in seinem vertikalen Abschnitt zur Verfügung gestellt werden kann. Wie in den Figuren 1 und 2 unter Weglassung einiger Komponenten vereinfacht dargestellt ist, entspricht die Länge des koplanar zum ersten Fördergurt angeordneten Bereichs des zweiten Fördergurtes in vertikaler Förderrichtung mindestens einem Drittel der Substratlänge. Die weitere Führung des zweiten Fördergurtes, der erfindungsgemäß neben seiner vertikalen Förderfunktion auch die Funktion des Transportbandes der DE 10 2006 011 870 B4 erbringt, verläuft weitgehend wie in dieser Druckschrift beschrieben durch Bereitstellung zweier Schenkel 23 und 24, wobei letzterer im Wesentlichen horizontal ausgerichtet ist.

Zur Unterstützung der Flüssigkeit vermittelten Adhäsion wird der zweite Fördergurt vorzugsweise mit einer Flüssigkeit befeuchtet oder benetzt, was beispielsweise in dem Bereich des umlaufenden Gurtes erfolgen kann, der aufgrund seiner geometrischen Ausrichtung nicht als Kontaktfläche für das Substrat in Betracht kommt. Besonders bevorzugt erfolgt die Benetzung in einem (vertikalen) dem Schenkel 24 anschließenden Abschnitt des zweiten Fördergurtes, sodass einem Substrat bereits im koplanar zum ersten Fördergurt verlaufenden Bereich des zweiten Fördergurtes ein die Adhäsion vermittelnder Flüssigkeitsfilm bereitgestellt werden kann. Am meisten bevorzugt wirkt auf den zweiten Fördergurt eine z.B. mittels Federkraft in ihrem Andruck einstellbare Abstreifrolle ein, die zwischen Benetzungsmittel und dem vertikalen, koplanaren Bereich des zweiten Fördergurtes angeordnet ist und eine exakte

Dosierung der benetzenden Flüssigkeit und damit eine präzise Einstellung des für die Adhäsion gewünschten Flüssigkeitsfilms ermöglicht.

Für ein sicheres Fixieren eines zu entnehmenden Substrates an dem ersten Fördergurt als Teil des Ansaugbandes ist ein aktiver Unterdruck notwendig, der sowohl mittels dynamischer Verfahren (z.B. Pumpe), statischer Verfahren (Unterdrucktank) oder sonstiger Verfahren innerhalb oder außerhalb der Vorrichtung erzeugt werden kann. Befinden sich der erste Fördergurt und das Substrat in unmittelbarem Kontakt, so dass sich nur noch ein sehr dünner Fluidfilm (wenige Nanometer bis zu 50 Mikrometer) zwischen Fördergurt und Substrat befindet, so bauen sich in dem engen Spalt Adhäsionskräfte auf, die von nun an ein selbsttätiges Festhalten bzw. Anhaften des Substrats an dem Fördergurt ermöglichen. Eine Aufrechterhaltung des aktiven Unterdruckes ist nun nicht mehr nötig.

Nach einer alternativen Ausführungsform kann die gewünschte Adhäsion auch durch ein Herausdrücken der Flüssigkeit zwischen den Flächen durch Annäherung derselben herbeigeführt werden, wobei erfindungsgemäß auch eine Kombination dieser Ausführungsformen in Betracht kommt.

Diese Adhäsionskräfte sind insbesondere größer als diejenigen zum nachfolgenden Substrat, so dass die Entnahme des zu vereinzelnden Substrats mit dem Gurtförderer parallel zur Flächenrichtung des nachfolgenden Substrats erfolgen kann. Dabei wirken allenfalls nur geringe Scherkräfte auf das zu vereinzelnde Substrat, wodurch die Bruchrate erheblich verringert wird. Zug- und Druckkräfte werden vermieden. Auch sind die Adhäsionskräfte bei entsprechend großer Flächenberührung größer als die durch den temporären Unterdruck erzeugten Kräfte. Ein im Zeittakt schnelles Entnehmen aus dem Substratstapel ist möglich. Die Adhäsionskräfte sind ferner so groß, dass sie, je nach geometrischer Ausgestaltung des Fördergurtes und Substratgewicht, insbesondere dann noch ein Anhaften von Substrat am Gurtförderer auch ohne aktive Unterdruckerzeugung ermöglichen, wenn sich das Substrat außerhalb des den Substratstapel umgebenden Fluids befindet. Nach einer weiteren Ausführungsform kann insbesondere der erste Fördergurt als flexibles Band aus einem geeigneten Material wie z.B. aus Kunststoff ausgestaltet sein, welches besonders bevorzugt so ausgestaltet ist, dass dessen Oberfläche für das Fluid passierbar ist, wodurch das Fluid sowohl ansaugbar und ausgebbar als auch verdrängbar ist. Hierzu können sowohl Öffnungen in Form von Bohrungen als auch in Form eines porösen Grundmaterials bereitgestellt werden.

Erfindungsgemäß wird der Unterdruck zu Beginn der Entnahmephase erzeugt. Auch wenn dieser Unterdruck nur bis zum Erhalt des oben genannten Fluidfilms zwischen Substrat und Kontaktfläche des ersten Fördergurtes aufrechterhalten bleiben muss, kann der Unterdruck auch aufrechterhalten bleiben, bis sich das Substrat auf dem im Wesentlichen horizontalen Abschnitt des zweiten Fördergurtes befindet.

Nach einer bevorzugten Ausführungsform weist der erfindungsgemäße Gurtförderer eine weitere Unterdruckeinrichtung auf, mit welcher der zweite Fördergurt im Bereich des an den koplanaren Bereich anschließenden Förderschenkels 23 mit Unterdruck beaufschlagt werden kann. Auf diese Weise wird das Schwenken oder Umlenken des Substrates gegenüber der Stirnseite des Stapels unterstützt und ein Wegkippen des Substrates entgegen der Transportrichtung ausgeschlossen, wobei der letztgenannte Effekt durch die Neigung des Förderschenkels 23 bereits weitgehend sichergestellt wird. Nach dieser Ausführungsform weist der zweite Fördergurt bevorzugt dieselben Eigenschaften wie der erste Fördergurt auf.

Die Trägereinrichtung ist derart aufgebaut, dass sie mindestens einen aus einer Vielzahl von Substraten bzw. Wafern bestehenden Substratstapel aufnehmen kann. Ferner weist die Trägereinrichtung bevorzugt Mittel wie insbesondere seitliche Bürstenleisten auf, durch welche sichergestellt wird, dass die einzelnen Substrate ggf. bis zu ihrer jeweiligen Entnahme sicher in Position gehalten werden. Vorzugsweise sind die Bürstenleisten klapp- oder verschwenkbar an der Trägereinrichtung angeordnet und können daher auch lediglich vorübergehend eingesetzt werden.

Die Trägereinrichtung ist zumindest in eine Richtung verschiebbar. Vorzugsweise ist sie in Vorschubrichtung verschiebbar, und zwar zunächst soweit, bis das erste zu vereinzelnde Substrat des Substratstapels an die ggf. vorhandene Lagebestimmungseinrichtung gelangt. Anschließend ist sie z.B. in Schritten verschiebbar, deren Schrittweite vorzugsweise der jeweiligen, im Normalfall über den Stapel hin konstanten Substratdicke entspricht, und zwar soweit, bis schließlich das letzte Substrat des Stapels an die Entnahmeeinrichtung herangeführt ist. Alternativ kann die Trägereinrichtung stationär ausgebildet sein. In diesem Falle würden geeignete Mittel bereitgestellt werden, mit denen der Substratstapel auf der Trägereinrichtung in Vorschubrichtung bewegt werden kann. Alternativ oder zusätzlich können der Gurtförderer sowie die ggf. vorhandene Lagebestimmungseinrichtung über entsprechend größere Freiheitsgrade verfügen, damit sie entgegen der Vorschubrichtung in Richtung des Stapelanfangs bewegbar sind.

Die bevorzugt vorgesehene Lagebestimmungseinrichtung ist eine Einrichtung, mit der die Lage und Position des zu vereinzelnden Substrats detektiert wird. Alternativ kommt die Verwendung eines Sensorelementes, beispielsweise in Form eines Berührungssensors, in Betracht, welches ein entsprechendes Signal ausgibt, wodurch der Gurtförderer das zu vereinzelnde Substrat vereinzeln und wegtransportieren kann.

Nach einem weiteren Aspekt wird erfindungsgemäß ein Verfahren bereitgestellt zum Vereinzeln, Umlenken und Transportieren von scheibenförmig ausgebildeten Substraten, die in einer Vorschubrichtung sequenziell hintereinander stehend in Form eines Substratstapels innerhalb einer Flüssigkeit angeordnet sind, mit einem vertikalen Gurtförderer mit mindestens zwei Fördergurten, wobei das fördernde Trum des ersten Fördergurtes auf einer Stirnseite des Substratstapels parallel zur Stirnseite angeordnet ist und der Gurtförderer eine Unterdruckeinrichtung aufweist, mit der das jeweils vorderste Substrat des Substratstapels an mindestens dem ersten Fördergurt ansaugbar ist, und wobei die mindestens zwei Fördergurte des vertikalen Gurtförderers in einem angrenzenden Bereich derart koplanar zueinander angeordnet sind, dass sich der zweite Fördergurt unter Fortsetzung des vertikalen Verlaufs des ersten Fördergurtes an diesen anschließt, und die Länge des koplanar zum ersten Fördergurt angeordneten Bereichs des zweiten Fördergurtes in vertikaler Förderrichtung mindestens einem Drittel der Substratlänge entspricht, und wobei der zweite Fördergurt im Anschluss an seinen koplanaren Bereich zwei Förderschenkel 23, 24 umfasst, deren erster Förderschenkel 23 im Anschluss an den koplanaren Bereich vorzugsweise geneigt verläuft. Das Verfahren umfasst die folgenden Schritte:
(A) Bereitstellen eines Substratstapels in einer eine Flüssigkeit enthaltenden Wanne vor dem ersten Fördergurt des Gurtförderers;
(B) Positionieren eines definierten Lochbildes des ersten Fördergurtes gegenüber der Stirnseite des Substratstapels;
(C) Bewegen des Substratstapels in Richtung des ersten Fördergurtes und in eine Ansaugposition;
(D) Detektieren der Ansaugposition des dem ersten Fördergurt nächstliegenden Substrates und Trennung des Substrates in der Wanne von dem Substratstapel;
(E) Ansaugen des Substrates in der Wanne mittels Unterdruck an das Lochbild des ersten Fördergurtes;
(F) Detektieren des angesaugten Substrates und Auslösen eines Fördertaktes des ersten Fördergurtes;
(G) Bewegen des Substrates mit dem ersten Fördergurt aus der Wanne und Weitergabe des Substrates an den zweiten Fördergurt;
(H) Schwenken des Substrates gegenüber der Stirnseite des Substratstapels derart, dass das Substrat auf den vorzugsweise geneigten ersten Förderschenkel gekippt wird;
(I) Positionieren des definierten Lochbildes des ersten Fördergurtes gegenüber der Stirnseite des Substratstapels beim Beenden des Fördertaktes des ersten Fördergurtes; und
(J) Wiederholung der Schritte (C) bis (I), bis der Substratstapel komplett vereinzelt ist.

Nach einer bevorzugten Ausführungsform erfolgt das Schwenken des Substrates gemäß Schritt (H) auf eine Fläche des an den koplanaren Bereich des zweiten Fördergurtes anschließenden Förderschenkels 23. Weiterhin wird bevorzugt, dass der zweite Fördergurt zur Begünstigung der Ausbildung einer Adhäsionskraft gegenüber dem Substrat befeuchtet oder benetzt wird. Schließlich weist der Gurtförderer vorzugsweise eine weitere Unterdruckeinrichtung auf, mit welcher der zweite Fördergurt im Bereich des an den koplanaren Bereich anschließenden Förderschenkels 23 mit Unterdruck beaufschlagt wird.

Weitere vorteilhafte Ausgestaltungen gehen aus der nachfolgenden Beschreibung, den Ansprüchen sowie den Zeichnungen hervor.

### Zeichnungen

Es zeigen:
- Fig. 1: eine schematische Darstellung der Vorrichtung des Standes der Technik gemäß DE 10 2006 011 870 B4;
- Fig. 2: eine schematische Darstellung der erfindungs-gemäßen Vorrichtung in Seitenansicht;
- Fig. 3: eine perspektivische Darstellung der in Fig. 2 gezeigten Ausführungsform.

In Figur 1 ist schematisch die Vorrichtung des Standes der Technik gemäß DE 10 2006 011 870 B4 dargestellt. Diese Vorrichtung ist geeignet zum Vereinzeln und Transportieren von scheibenförmig ausgebildeten Substraten.

Die Vereinzelungsvorrichtung 1 zeigt eine Wanne 2, in der die zu vereinzelnden plattenförmigen Substrate 3, beispielsweise Siliziumplatten, in einer Trägereinrichtung 4 stehend aufgenommen sind und einen stehenden Stapel 5 bilden, wobei die Wanne 2 bis zu einem oberen Rand 6 mit einer Flüssigkeit 7 gefüllt ist. Die Wanne 7 ist auf einem Antrieb 8 montiert, der die Trägereinrichtung 4 durch Bewegen der Wanne 2 einem Gurtförderer 9 zur Vereinzelung und zum Abtransport zuführt. Die Flüssigkeit 7 ist eine Reinigungsflüssigkeit, die Wanne 2 ein Reinigungsbad.

Der Gurtförderer 9 weist ein förderndes Trum 10 auf, dessen Fördergurt 11 gegenüberliegend einer Stirnseite 12 des Stapels 5 parallel zu der Stirnseite 12 angeordnet ist. Das Trum 10 umfasst neben dem Fördergurt 11 zwei weitere Fördergurte 11' und 11'', die mit einer in der Zeichnung nicht dargestellten, geeigneten Beschichtung, beispielsweise Sylomer®, versehen sein können und die die Siliziumplatten 3 vom Fördergurt 11 übernehmen und weiter transportieren.

Der Fördergurt 11, der Teil eines Ansaugbandes 13 ist, weist ein definiertes Lochbild 14 auf, durch das mittels einer Pumpe 15, die Teil einer Unterdruckeinrichtung 16 ist, über eine Ansaugplatte 17 die Flüssigkeit 7 aus der Wanne 2 angesaugt werden kann. Zur Detektierung einer Ausgangsposition 18 der an der Stirnseite 12 des Stapels 5 befindlichen Siliziumplatte 3 ist ein Lagesensor 19 vorgesehen, der den als Linearachse ausgebildeten Antrieb 8 stoppt und über ein Ansaugventil die Flüssigkeit durch den Fördergurt 11 des Ansaugbandes 13 ansaugt. Dadurch wird die vorderste Siliziumplatte des Stapels 5 an den Fördergurt 11 des Ansaugbandes 13 angesaugt.

Ein Druckschalter 21 erkennt, dass die Siliziumplatte 3 angesaugt ist, und startet einen Transporttakt des Ansaugbandes 13. Der Druckschalter 21 ist in der Ansaugplatte 17 dargestellt. Er kann mittels eines T-Stücks (nicht dargestellt) an eine zur Ansaugplatte 17 führende Ansaugleitung der Unterdruckeinrichtung 16 angeschlossen sein. Mit der Bewegung des ansaugenden Fördergurtes 11 wird die mittels Unterdruck daran festgelegte Siliziumplatte 3 von der Stirnseite 12 des Stapels 5 entfernt. Über Ansaugkanäle 22 in der Ansaugplatte 17 bleibt die Siliziumplatte 3 beim Umlaufen des Fördergurtes 11 weiterhin an dem Fördergurt 11 des Ansaugbandes 13 angesaugt, bis die Siliziumplatte 3 nach oben in einen Spalt 29 zwischen dem Ansaugband 13 und dem parallel dazu angeordneten Abstützungsband 13' transportiert ist.

Alternativ kann der Fördergurt 11 kontinuierlich angetrieben werden. Der Antrieb wird nur unterbrochen, wenn sich keine Siliziumplatte 3 in einer Abholposition auf einem Lochbild 14 des Fördergurtes 11 befindet. Das detektiert der Druckschalter 21. Sobald sich eine Siliziumplatte 3 vor dem Lochbild 14 befindet, wird der Fördergurt 11 wieder angefahren.

Nachdem sich das Lochbild 14 des Fördergurtes 11 von dem Bereich der Ansaugplatte 17 entfernt hat, der die Ansaugkanäle 22 aufweist, wird die Siliziumplatte 3 zwischen dem Unterstützungsband 13' und dem Ansaugband 11 und/oder einem auf das Ansaugband 11 folgenden Transportband 13" geklemmt und nach oben transportiert. Der Fördergurt 11' des Abstützungsbandes 13' und der Fördergurt 11" des Transportbandes 13" weist in dem dargestellten Ausführungsbeispiel kein Lochbild und keine Unterdruckeinrichtung auf.

Das Ansaugband 13 und das Abstützungsband 13' sind vertikal verlaufende lineare Bänder, die versetzt in einem geringen Abstand zueinander angeordnet sind. Sie bilden zwischen sich den Spalt 29. Das Transportband 13", das die Siliziumplatte 3 von dem Ansaugband 13 übernimmt, ist geknickt ausgeführt. Der an das Ansaugband 13 angrenzende Schenkel 23 des Transportbandes 13" weist eine typische Neigung von 45° auf, während der freie Schenkel 24 horizontal angeordnet ist. Somit wird die in der Trägereinrichtung 4 stehend aufgenommene Siliziumplatte 3 während des Vereinzelungsvorganges um einen Winkel von 90° um ihre Querachse geschwenkt und am Ende des fördernden Trums 10 des Gurtförderers 9 in liegender Stellung bereitgestellt. Reicht der Winkel von 45° nicht für einen zuverlässigen Transport der Siliziumplatten 3 aus, kann der Winkel des Transportbandes 13" zu einer gedachten Horizontalen verringert werden auf beispielsweise 30°. Die Siliziumplatten 3 werden dann zunächst um 60° und anschließend um 30° anstatt zweimal um 45° um insgesamt 90° aus der ursprünglich vertikalen in die horizontale Lage geschwenkt und gefördert.

Die Fördergurte 11, 11" können einen gemeinsamen Antrieb aufweisen. Weisen sie jeweils eigene Antriebe auf, lassen sich durch unterschiedliche Gurtgeschwindigkeiten oder durch Anhalten eines der beiden Fördergurte 11, 11" während der andere Fördergurt 11", 11 weiterläuft die vereinzelten Siliziumplatten 3 "auseinanderziehen", d. h. ihr Abstand vergrößern (oder auch verkleinern).

An einem oberen Ende 25 des Abstützungsbandes 13' ist ein Abweiser 26 angebracht, der zusammen mit dem Abstützungsband 13' die Führungselemente 13', 26 des Gurtförderers 9 bildet, die auf die Siliziumplatte 3 einwirken, nachdem diese nicht mehr durch Unterdruck an dem Fördergurt 11 des Ansaugbandes 13 gehalten ist. Die Siliziumplatte 3 wird beim Anlaufen an den Abweiser 26 auf den geneigten Schenkel 23 des Transportbandes 13" gekippt, welches die Siliziumplatte 3 weiterbewegt, bis sie infolge der Schwerkraft am Ende des geneigten Schenkels 23 auf den horizontalen Schenkel 24 des Transportbandes 13" kippt. Anstelle des dargestellten Abweisers 26 können auch ein oder mehrere Bürstenleisten als Abweiser zum sicheren Ablösen der Siliziumplatten 3 vom Abstützungsband 13' und zum Kippen auf das Transportband 13" im Bereich des oberen Endes des Abstützungsbandes 13' angeordnet sein (nicht dargestellt).

Das Ansaugband 13 weist einen getakteten, in der Zeichnung nicht dargestellten Antrieb auf, der auch das Transportband 13" sowie das Abstützungsband 13' direkt oder indirekt antreiben kann. So ist es beispielsweise möglich, mit dem Fördergurt 11 des Ansaugbandes 13 mittels Reibschluss auf den Fördergurt 11" des Transportbandes 13" einzuwirken, der wiederum über die geklemmte Siliziumplatte den Fördergurt 11' des Abstützungsbandes 13' antreiben kann.

Über einen Lochbildsensor 27 wird die Position des Lochbildes 14 des Fördergurtes 11 detektiert, das in dem dargestellten Ausführungsbeispiel zweimal vorhanden ist. Dementsprechend beträgt der Fördertakt des Ansaugbandes 13 eine halbe Umdrehung des Fördergurtes 11. Der Lochbildsensor 27 ist auf einer Rücklaufseite des Ansaugbandes 13 angeordnet und stoppt den Fördergurt 11, sobald ein Lochbild 14 über den Ansaugkanälen 22 gegenüber der Stirnseite 12 des Stapels 5 positioniert ist. In dieser Stellung verbleibt der Fördergurt 11, bis sich eine Siliziumplatte 3 dem fördernden Trum 10 soweit angenähert hat, dass sie in der Ausgangsposition 18 von dem Lagesensor 19 erkannt wird, der die Unterdruckeinrichtung 16 steuert, und die Siliziumplatte 3 von der Unterdruckeinrichtung 16 angesaugt worden ist.

Um die Trennung der vordersten Siliziumplatte 3 von dem Stapel 5 zu erleichtern, wird mittels einer Düse 28 und einer in der Zeichnung nicht dargestellten Pumpe Flüssigkeit 7 aus der Wanne 2 zwischen die beiden dem Lochbild 14 nächst liegenden Siliziumplatten 3 gespritzt, wodurch diese separiert werden.

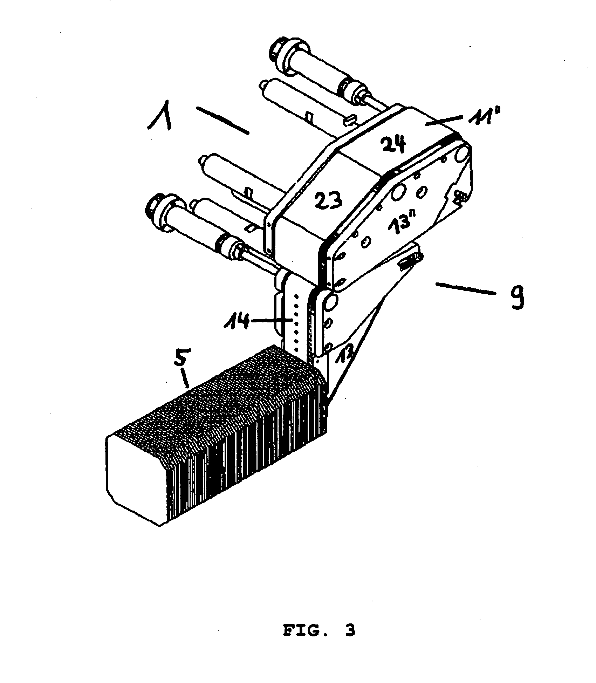

In den Figuren 2 und 3 ist eine bevorzugte Ausführungsform der erfindungsgemäß weitergebildeten Vorrichtung 1 zur Vereinzelung eines Substratstapels 5 dargestellt. Bei diesem Ausführungsbeispiel sind die Substrate 3 in einem Substratstapel 5 angeordnet, wobei der Substratstapel 5 in einer Trägereinrichtung (nicht dargestellt) gelagert ist. Die einzelnen Substrate 3 sind bereits von einer Halteeinrichtung gelöst. Bei der Anordnung der Vorrichtung 1 innerhalb eines Fluids kann es vorkommen, dass die einzelnen Substrate 3 aufschwimmen oder die Trägereinrichtung ungewollt verlassen, weshalb die Trägereinrichtung bevorzugt zwei seitliche, parallel zueinander in Transportrichtung verlaufende Bürstenleisten aufweist, welche die Substrate innerhalb des stehenden Stapels vorübergehend wie z.B. während des Transports der Trägereinrichtung zur Vereinzelungsvorrichtung bis zu ihrer jeweiligen Entnahme seitlich abstützen. Besonders bevorzugt sind die Bürstenleisten lösbar oder klappbar an der Trägereinrichtung angeordnet. Alternativ oder zusätzlich können die Substrate und damit der Substratstapel innerhalb der Trägereinrichtung leicht entgegen der Vorschub- bzw. Transportrichtung geneigt positioniert sein.

Die einzelnen flächig ausgebildeten Substrate 3 sind derart aneinandergereiht, dass sich deren Oberflächen berühren. Zwischen ihnen wirken Adhäsionskräfte, die von dem sehr kleinen Spalt zwischen den Substraten einerseits und ggf. von Verunreinigungen z.B. durch einen vorangegangenen Sägeschritt herrühren. Durch diese Anordnung geben die Substrate 3 eine definierte Vorschubrichtung vor.

Ferner ist erfindungsgemäß ein Gurtförderer 9 mit einem fördernden Trum 10 sowie zwei Fördergurten 11 und 11'' vorgesehen, die jeweils einen Teil des Ansaugbandes 13 bzw. des Transportbandes 13" bilden. Das mindestens eine Lochbild des Ansaugbandes 13 ist in Figur 3 dargestellt und entspricht weitestgehend der vorhergehenden Beschreibung zu Figur 1. Der Fördergurt 11" schließt sich unter Fortsetzung des vertikalen Verlaufs des Fördergurtes 11 an diesen Fördergurt 11 an, wobei der vertikal verlaufende Abschnitt des Fördergurtes 11'' bevorzugt mindestens einem Drittel der Substratlänge in Förderrichtung entspricht. Der Fördergurt 11'' verläuft im Anschluss an diesen vertikalen Teilbereich geneigt, wie z.B. in einem Winkel von 45°, bevor er innerhalb eines dritten Abschnittes horizontal geführt wird. Die bevorzugt vorgesehene weitere Unterdruckeinrichtung 20 befindet sich unterhalb des zweiten Fördergurtes 11 " im zweiten Abschnitt des Förderschenkels 23.

Bevorzugt ist vorgesehen, dass zumindest bestimmte Teile der Vorrichtung 1, nämlich die Trägereinrichtung, der Substratstapel 5, sowie Teile des Gurtförderers 9 innerhalb eines Fluids angeordnet sind. Hierdurch wird erreicht, dass die Substrate über die Dauer des gesamten Verfahrens, zumindest bis zu ihrer vollständigen Vereinzelung, nicht trockenfallen.

Die vorliegende Erfindung wurde im Hinblick auf die Behandlung von Siliziumwafern dargelegt. Selbstverständlich können auch scheibenförmige Substrate aus anderen Materialien wie z.B. Kunststoff erfindungsgemäß bearbeitet werden.

### Bezugszeichenliste

- 1: Vorrichtung
- 2: Wanne
- 3: Substrat, Siliziumplatte
- 4: Trägereinrichtung
- 5: Substratstapel, Stapel
- 6: Oberer Rand
- 7: Flüssigkeit
- 8: Antrieb
- 9: Gurtförderer
- 10: Förderndes Trum
- 11: Erster Fördergurt (als Teil des Ansaugbandes 13)
- 11': Fördergurt (als Teil des Abstützungsbandes 13')
- 11": Zweiter Fördergurt (als Teil des Transportbandes)
- 12: Stirnseite des Stapels
- 13: Ansaugband
- 13': Abstützungsband
- 13 ": Transportband
- 14: Lochbild
- 15: Pumpe
- 16: Unterdruckeinrichtung
- 17: Ansaugplatte
- 18: Ausgangsposition
- 19: Lagesensor
- 20: Weitere Unterdruckeinrichtung
- 21: Druckschalter
- 22: Ansaugkanäle
- 23: Geneigter Schenkel des Transportbandes 13'
- 24: Horizontaler Schenkel des Transportbandes 13'
- 25: Oberes Ende des Abstützungsbandes 13'
- 26: Abweiser
- 27: Lochbildsensor
- 28: Separiermittel

## Patentansprüche

1. Vorrichtung (1) zum Vereinzeln, Umlenken und Transportieren von scheibenförmig ausgebildeten Substraten (3), die in einer Vorschubrichtung sequenziell hintereinander stehend in Form eines Substratstapels (5) innerhalb einer Flüssigkeit angeordnet sind, umfassend einen vertikalen Gurtförderer (9) mit mindestens zwei Fördergurten (11, 11"), wobei ein erster Fördergurt (11) auf einer Stirnseite (12) des Substratstapels (5) parallel zur Stirnseite (12) angeordnet ist und der Gurtförderer (9) eine Unterdruckeinrichtung (16) aufweist, mit der das jeweils vorderste Substrat (3) des Substratstapels (5) an mindestens dem ersten Fördergurt (11) ansaugbar ist, wobei die mindestens zwei Fördergurte (11, 11") des vertikalen Gurtförderers (9) in einem angrenzenden Bereich derart koplanar zueinander angeordnet sind, dass sich der zweite Fördergurt (11") unter Fortsetzung des vertikalen Verlaufs des ersten Fördergurtes (11) an diesen anschließt, und
wobei der zweite Fördergurt (11") im Anschluss an seinen koplanaren Bereich einen Förderschenkel (23) umfasst, der im Anschluss an den koplanaren Bereich geneigt verläuft, **dadurch gekennzeichnet, dass** die Länge des koplanar zum ersten Fördergurt (11) angeordneten Bereichs des zweiten Fördergurtes (11'') in vertikaler Förderrichtung mindestens einem Drittel der Substratlänge entspricht.

2. Vorrichtung nach Anspruch 1, **dadurch gekennzeichnet, dass** der Gurtförderer (9) eine weitere Unterdruckeinrichtung (20) aufweist, mit welcher der zweite Fördergurt (11") im Bereich des an den koplanaren Bereich anschließenden Förderschenkels (23) mit Unterdruck beaufschlagbar ist.

3. Vorrichtung nach Anspruch 1 oder 2, **dadurch gekennzeichnet, dass** sie ferner Separiermittel (28) zum Auffächern zumindest eines Teils des Substratstapels (5) umfasst.

4. Vorrichtung nach einem der vorhergehenden Ansprüche, **dadurch gekennzeichnet, dass** sie ferner eine in mindestens eine Richtung verschiebbare Trägereinrichtung (4) umfasst, in der der Substratstapel (5) gelagert ist.

5. Vorrichtung nach Anspruch 4, **dadurch gekennzeichnet, dass** die Trägereinrichtung (4) zwei seitlich parallel zueinander angeordnete Bürstenleisten aufweist.

6. Vorrichtung nach Anspruch 5, **dadurch gekennzeichnet, dass** die Bürstenleisten klapp- oder verschwenkbar angeordnet sind.

7. Verfahren zum Vereinzeln, Umlenken und Transportieren von scheibenförmig ausgebildeten Substraten (3), die in einer Vorschubrichtung sequenziell hintereinander stehend in Form eines Substratstapels (5) innerhalb einer Flüssigkeit angeordnet sind, mit einem vertikalen Gurtförderer (9) mit mindestens zwei Fördergurten (11, 11"), wobei ein erster Fördergurt (11) auf einer Stirnseite (12) des Substratstapels (5) parallel zur Stirnseite (12) angeordnet ist und der Gurtförderer (9) eine Unterdruckeinrichtung (16) aufweist, mit der das jeweils vorderste Substrat (3) des Substratstapels (5) an mindestens dem ersten Fördergurt (11) ansaugbar ist, und wobei die mindestens zwei Fördergurte (11, 11") des vertikalen Gurtförderers (9) in einem angrenzenden Bereich derart koplanar zueinander angeordnet sind, dass sich der zweite Fördergurt (11") unter Fortsetzung des vertikalen Verlaufs des ersten Fördergurtes (11) an diesen anschließt, und die Länge des
koplanar zum ersten Fördergurt (11) angeordneten Bereichs des zweiten Fördergurtes (11") in vertikaler Förderrichtung mindestens einem Drittel der Substratlänge entspricht, und wobei der zweite Fördergurt (11'') im Anschluss an seinen koplanaren Bereich einen Förderschenkel (23) umfasst, der im Anschluss an den koplanaren Bereich geneigt verläuft,
umfassend die folgenden Schritte:
(A) Bereitstellen eines Substratstapels (5) in einer eine Flüssigkeit enthaltenden Wanne vor dem ersten Fördergurt (11) des Gurtförderers (9) ;
(B) Positionieren eines definierten Lochbildes (14) des ersten Fördergurtes (11) gegenüber der Stirnseite (12) des Substratstapels (5);
(C) Bewegen des Substratstapels (5) in Richtung des ernsten Fördergurtes (11) und in eine Ansaugposition;
(D) Detektieren der Ansaugposition des dem ersten Fördergurt (11) nächstliegenden Substrates (3) und Trennung des Substrates in der Wanne von dem Substratstapel (5);
(E) Ansaugen des Substrates (3) in der Wanne mittels Unterdruck an das Lochbild (14) des ersten Fördergurtes (11);
(F) Detektieren des angesaugten Substrates (3) und Auslösen eines Fördertaktes des ersten Fördergurtes (11);
(G) Bewegen des Substrates (3) mit dem ersten Fördergurt (11) aus der Wanne und Weitergabe des Substrates an den zweiten Fördergurt (11");
(H) Schwenken des Substrates (3) gegenüber der Stirnseite (12) des Substratstapels (5) derart, dass das Substrat (3) auf den geneigten Förderschenkel (23) gekippt wird:
(I) Positionieren des definierten Lochbildes (14) des ersten Fördergurtes (11) gegenüber der Stirnseite (12) des Substratstapels (5) beim Beenden des Fördertaktes des ersten Fördergurtes (11); und
(J) Wiederholung der Schritte (C) bis (I), bis der Substratstapel komplett vereinzelt ist.

8. Verfahren nach Anspruch 7, **dadurch gekennzeichnet, dass** das Schwenken des Substrates gemäß Schritt (H) auf eine Fläche des an den koplanaren Bereich des zweiten Fördergurtes (11") anschließenden Förderschenkels (23) erfolgt.

9. Verfahren nach Anspruch 8, **dadurch gekennzeichnet, dass** der zweite Fördergurt (11'') zur Begünstigung der Ausbildung einer Adhäsionskraft gegenüber dem Substrat befeuchtet wird.

10. Verfahren nach einem der Ansprüche 7 bis 9, **dadurch gekennzeichnet, dass** der Gurtförderer (9) eine weitere Unterdruckeinrichtung (20) aufweist, mit welcher der zweite Fördergurt (11") im Bereich des an den koplanaren Bereich anschließenden Förderschenkels (23) mit Unterdruck beaufschlagt wird.

## Claims

1. Apparatus (1) for the separating, deflecting and transporting of disc shaped substrates (3) which are sequentially arranged standing one after another in a feed direction in the form of a substrate stack (5) within a liquid, comprising a vertical belt conveyor (9) with at least two conveyor belts (11, 11"), wherein a first conveyor belt (11) is arranged at one front side (12) of the substrate stack (5) parallel to the front side (12), and wherein the belt conveyor (9) has a vacuum device (16) by means of which the respective foremost substrate (3) of the substrate stack (5) can be sucked against at least the first conveyor belt (11), wherein the at least two conveyor belts (11, 11") of the vertical belt conveyor (9) are arranged coplanar to each other in an adjoining region such that the second conveyor belt (11") adjoins to the first conveyor belt (11) in continuation of its vertical course, and wherein the the second conveyor belts (11") subsequent to its coplanar region comprises a conveying leg (23) which runs inclined subsequent to the coplanar region, **characterized in that** the length of the second conveyor belt (11") region which is arranged coplanar to the first conveyor belt (11) corresponds, in vertical conveying direction, to at least a third of the substrate length.

2. Apparatus according to claim 1, **characterized in that** the belt conveyor (9) has a further vacuum device (20) by means of which the second conveyor belt (11") can be pressurized in the region of the conveyor leg (23) which follows the coplanar region.

3. Apparatus according to claim 1 or 2, **characterized in that** it further comprises separation means (28) for the fanning of at least a part of the substrate stack (5).

4. Apparatus according to any of the preceding claims, **characterized in that** it further comprises a carrier device (4) which is moveable into at least one direction, in which the substrate stack (5) is stored.

5. Apparatus according to claim 4, **characterized in that** the carrier device (4) has two brush strips which are laterally arranged parallel to each other.

6. Apparatus according to claim 5, **characterized in that** the brush strips are arranged foldable or slewable.

7. Method for the separating, deflecting and transporting of disc shaped substrates (3) which are sequentially arranged standing one after another in a feed direction in the form of a substrate stack (5) within a liquid, with a vertical belt conveyor (9) with at least two conveyor belts (11, 11"), wherein a first conveyor belt (11) is arranged at one front side (12) of the substrate stack (5) parallel to the front side (12) and the belt conveyor (9) has a vacuum device (16) by means of which the respective foremost substrate (3) of the substrate stack (5) can be sucked against at least the first conveyor belt (11), and wherein the at least two conveyor belts (11, 11") of the vertical belt conveyor (9) are arranged coplanar to each other in an adjoining region, such that the second conveyor belt (11") adjoins to the first conveyor belt (11) in continuation of its vertical course, and the length of the second conveyor belts' (11") region which is arranged coplanar to the first conveyor belt (11) corresponds, in vertical conveying direction, to at least a third of the substrate length, wherein the second conveyor belt (11") subsequent to its coplanar region comprises a conveying leg (23) which runs inclined subsequent to the coplanar region, comprising the following steps:
(A) Providing a substrate stack (5) in a basin containing a liquid in front of the first conveying belt (11) of the belt conveyor (9);
(B) positioning a defined hole pattern (14) of the first conveyor belt (11) adjacent to the front side (12) of the substrate stack (5);
(C) moving the substrate stack (5) in direction of the first conveyor belt (11) and in a suction position;
(D) detecting the suction position of the substrate (3) which is next to the first conveyor belt (11) and separation of the substrate in the basin from the substrate stack (5);
(E) sucking the substrate (3) in the basin by means of vacuum against the hole pattern (14) of the first conveyor belt (11);
(F) detecting the sucked substrate (3) and triggering a conveyor sequence of the first conveyor belt (11);
(G) moving the substrate (3) by means of the first conveyor belt (11) out of the basin and handing over of the substrate to the second conveyor belt (11");
(H) slewing the substrate (3) with respect to the front side (12) of the substrate stack (5) in such a way, that the substrate (3) will toppled onto the sloped conveying leg (23);
(I) positioning of the defined hole pattern (14) of the first conveyor belt (11) with respect to the front side (12) of the substrate stack (5) upon finishing the conveyor sequence of the first conveying belt (11); and
(J) repeating steps (C) to (I), until the substrate stack is completely separated.

8. Method according to claim 7, **characterized in that** the slewing of the substrate according to step (H) takes place on to a surface of the conveyor leg (23) which follows the coplanar region of the second conveyor belt (11").

9. Method according to claim 8, **characterized in that** the second conveyor belt (11") is humidified in order to enhance the formation of an adhesion force in regard of the substrate.

10. Method according to any of claims 7 to 9, **characterized in that** the belt conveyor (9) has a further vacuum device (20) by means of which the second conveyor belt (11") is pressurized in the region of the conveyor leg (23) which follows the coplanar region.

## Revendications

1. Dispositif (1) pour séparer, changer la direction et transporter des substrats (3) façonnés en forme de disque qui sont placés dans un liquide sous la forme d'un banc de substrats (5) ordonnés debout séquentiellement les uns derrières les autres dans une direction du transport, comprenant un convoyeur à courroies vertical (9) avec au moins deux courroies transporteuses (11, 11"), dans lequel une première courroie (11) sur le coté frontal (12) du banc de substrats (5) est parallèle au coté frontal (12) et le convoyeur à courroies (9) est doté d'un mécanisme de dépressurisation (16) avec lequel le substrat (3) qui se trouve à son tour à l'avant du banc de substrats (5) peut être aspiré au moins sur la première courroie transporteuse (11), et dans lequel les, au moins, deux courroies (11, 11") du convoyeur à courroies vertical (9) sont coplanaires l'une par rapport à l'autre dans une région adjacente de telle manière que la deuxième courroie transporteuse (11") est accolée à la suite de la première courroie transporteuse (11) dans le plan vertical de cette dernière, et dans lequel la deuxième courroie transporteuse (11") comprend à la suite de sa région coplanaire une aile transporteuse (23) qui est inclinée à la suite de la région coplanaire, **caractérisé en ce que** la longueur de la région de la deuxième courroie transporteuse (11") coplanaire à la première courroie transporteuse (11) dans la direction verticale du transport correspond à au moins un tiers de la longueur du substrat.

2. Dispositif selon la revendication 1, **caractérisé en ce que** le convoyeur à courroie (9) est doté d'un mécanisme de dépressurisation supplémentaire (20) avec lequel la deuxième courroie transporteuse (11") dans la région de l'aile transporteuse (23) à la suite de la région coplanaire peut être mise en dépressurisation.

3. Dispositif selon les revendications 1 ou 2, **caractérisé en ce qu'**il comprend de plus un ou des agent(s) de séparation (28) pour déliasser au moins une partie du banc de substrats (5).

4. Dispositif selon une des revendications précédentes, **caractérisé par** ce qu'il comprend de plus un élément porteur (4) déplaçable dans au moins une direction dans lequel repose le banc de substrats (5).

5. Dispositif selon la revendication 4, **caractérisé par** ce que l'élément porteur (4) est doté de deux barrettes de brosses ordonnées parallèlement l'une à l'autre latéralement.

6. Dispositif selon la revendication 5, **caractérisé par** ce que les barrettes de brosses sont rabattables ou déplaçables.

7. Procédé pour séparer, changer la direction et transporter des substrats (3) façonnés en forme de disque qui sont placés dans un liquide sous la forme d'un banc de substrats (5) ordonnés debout séquentiellement les uns derrières les autres dans une direction du transport, avec un convoyeur à courroies vertical (9) avec au moins deux courroies transporteuses (11, 11"), dans lequel une première courroie (11) sur le coté frontal (12) du banc de substrats (5) est parallèle au coté frontal (12) et le convoyeur à courroies (9) est doté d'un mécanisme de dépressurisation (16) avec lequel le substrat (3) qui se trouve à son tour à l'avant du banc de substrats (5) peut être aspiré au moins sur la première courroie transporteuse (11), et dans lequel les, au moins, deux courroies (11, 11") du convoyeur à courroies vertical (9) sont coplanaires l'une par rapport à l'autre dans une région adjacente de telle manière que la deuxième courroie transporteuse (11") est accolée à la suite de la première courroie transporteuse (11) dans le plan vertical de cette dernière, et la longueur de la région de la deuxième courroie transporteuse (11") coplanaire à la première courroie transporteuse (11) dans la direction verticale du transport correspond à au moins un tiers de la longueur du substrat, et dans lequel la deuxième courroie transporteuse (11") comprend à la suite de sa région coplanaire une aile transporteuse (23) qui est inclinée à la suite de la région coplanaire, comprenant les étapes suivantes :
(A) Mettre à disposition un banc de substrats (5) dans un bac contenant du liquide devant la première courroie transporteuse (11) du convoyeur à courroies (9);
(B) Positionner un gabarit de trous (14) défini de la première courroie transporteuse (11) en face du coté frontal (12) du banc de substrats (5);
(C) Déplacer le banc de substrats (5) en direction de la première courroie transporteuse (11) et dans une position d'aspiration;
(D) Détecter la position d'aspiration du substrat (3) le plus proche de la première courroie transporteuse (11) et séparation du substrat du banc de substrats (5) dans le bac;
(E) Aspirer le substrat (3) dans le bac par dépressurisation au niveau du gabarit de trous (14) de la première courroie transporteuse (11);
(F) Détecter le substrat (3) aspiré et déclenchement d'un cycle de transport de la première courroie transporteuse (11);
(G) Sortir le substrat (3) du bac avec la première courroie (11) et transfert du substrat à la deuxième courroie de transmission (11");
(H) Basculer le substrat (3) par rapport au coté frontal (12) du banc de substrats (5) de telle manière que le substrat (3) soit basculé sur l'aile transporteuse (23) inclinée;
(I) Positionner le gabarit de trous (14) défini de la première courroie transporteuse (11) en face du coté frontal (12) du banc de substrat (5) à la fin du cycle de transport de la première courroie transporteuse (11); et
(J) Répéter les étapes (C) à (I) jusqu'à ce que le banc de substrats soit complètement séparé.

8. Procédé selon la revendication 7, **caractérisé en ce que** le basculement du substrat selon l'étape (H) s'effectue sur une surface de l'aile transporteuse (23) à la suite de la région coplanaire de la deuxième courroie transporteuse (11").

9. Procédé selon la revendication 8, **caractérisé en ce que** la deuxième courroie transporteuse (11") est humidifiée pour favoriser la formation d'une force adhésive agissant sur le substrat.

10. Procédé selon une des revendications 7 à 9, **caractérisé en ce que** le convoyeur à courroie (9) est doté d'un mécanisme dépressurisant (20) supplémentaire avec lequel la deuxième courroie transporteuse (11") dans la région de l'aile transporteuse (23) à la suite de la région coplanaire peut être mise en dépressurisation.
